(19) Europäisches Patentamt
European Patent Office
Office européen des brevets

(11) **EP 2 657 497 B1**

(12) **EUROPÄISCHE PATENTSCHRIFT**

(45) Veröffentlichungstag und Bekanntmachung des Hinweises auf die Patenterteilung:
**26.11.2014 Patentblatt 2014/48**

(51) Int Cl.:
***F02G 1/043*** *(2006.01)*

(21) Anmeldenummer: **12165774.6**

(22) Anmeldetag: **26.04.2012**

(54) **Thermoelektrischer Wandler mit verbessertem Wärmeüberträger**

Thermo-electric converter with improved heat transmitter

Convertisseur thermoélectrique avec caloporteur amélioré

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**30.10.2013 Patentblatt 2013/44**

(73) Patentinhaber: **Ittner, Thilo**
**88212 Ravensburg (DE)**

(72) Erfinder: **Ittner, Thilo**
**88212 Ravensburg (DE)**

(74) Vertreter: **Grünecker, Kinkeldey,**
**Stockmair & Schwanhäusser**
**Leopoldstrasse 4**
**80802 München (DE)**

(56) Entgegenhaltungen:
**EP-A1- 2 258 947       WO-A2-2008/146109**
**DE-U1-202005 017 622**

## Beschreibung

Die vorliegende Erfindung betrifft einen thermoelektrischen Wandler mit einem verbesserten Wärmeüberträger zum Austausch von Wärme mit einem Arbeitsgas.

## Stand der Technik

Im Stand der Technik sind bereits verschiedene Vorrichtungen zur Umwandlung von Wärmemengen in elektrische Energie oder von elektrischer Energie in Wärmemengen bekannt. Diese finden in vielen Bereichen Anwendung und enthalten üblicherweise zur Veränderung des Volumens eines eingesetzten Arbeitsgases Kolben oder Membranen. Diese Volumenänderungselemente können entweder mechanisch durch beispielsweise Kurbelwellen oder, wie in den EP 2258947 A1 und WO 2008146109 beschrieben, elektromagnetisch angetrieben werden. Weiterhin weisen diese Maschinen typischerweise mehrere Arbeitsräume auf, zwischen denen sich die Temperatur des verwendeten Arbeitsgases ändert, wobei dadurch eine Druckänderung bewirkt wird. Für Maschinen, die insbesondere regenerative Gaskreisprozesse ausnutzen, ist ferner bekannt, dass ein Regenerator eingesetzt wird, der zwischen den Arbeitsräumen vorgesehen ist. Dieser Regenerator speichert die abgegebene Wärme des durchströmenden Gases und gibt sie beim Rückströmen des Gases wieder an dieses ab.

Im bisherigen Stand der Technik treten jedoch mehrere technische Probleme auf, aufgrund derer im realisierten Kreisprozess nur ein Wirkungsgrad erreicht werden kann, der wesentlich geringer als der theoretisch mögliche Wirkungsgrad eines Carnot-Kreisprozesses ist. Diese Probleme sind insbesondere das Auftreten von Totvolumina, wobei es sich dabei um Volumenanteile handelt, aus denen das Arbeitsgas während des Kreisprozesses nicht entfernt werden kann. Das sind vor allem die Bereiche der Wärmetauscher und der Regeneratoren. Eines der größten Probleme ist der Umstand, dass es aufgrund der endlichen Geschwindigkeit der Wärmeübertragung innerhalb des Arbeitsgases nicht möglich ist, Zustandsänderungen tatsächlich isotherm durchzuführen, da der Wärmetauscher nur Gas in einem bestimmten Bereich um ihn herum erwärmen kann.

## Aufgabe

Der Erfindung liegt daher die Aufgabe zugrunde, einen thermoelektrischen Wandler mit verbessertem Wärmeüberträger zur Verfügung zu stellen.

Diese Aufgabe ist durch die Vorrichtung nach Anspruch 1 und das Verfahren nach Anspruch 9 gelöst. Zweckmäßige Ausgestaltungen der Erfindung sind in den Unteransprüchen erfasst.

Der thermoelektrische Wandler zur Umwandlung von Wärmemengen in elektrische Energie oder elektrische Energie in Wärmemengen oder Wärmemengen mit gewissen Temperaturen in Wärmemengen mit gewissen anderen Temperaturen, der wenigstens zwei miteinander verbundene Primärvolumina umfasst, die jeweils ein Gasvolumen umfassen, das für die Aufnahme eines Gases geeignet ist und wobei mindestens eines der Primärvolumina oder beide ein Flüssigkeitsvolumen umfassen, das für die Aufnahme einer Flüssigkeit geeignet ist, wobei die Flüssigkeit thermisch an ein Wärmereservoir (eine externe Wärmequelle oder Wärmesenke) koppelbar ist und wobei mindestens ein Volumenänderungselement in wenigstens einem der Primärvolumina zur Änderung der Größe des Gasvolumens vorgesehen ist, zeichnet sich dadurch aus, dass weiterhin ein Wärmeübertragungselement in wenigstens einem der Primärvolumina vorgesehen ist und der Anteil des Wärmeübertragungselements, der sich im Flüssigkeitsvolumen befindet, variabel ist. Befindet sich in dem Flüssigkeitsvolumen eine Flüssigkeit, die thermisch an ein externes Wärmereservoir koppelbar ist, so ermöglicht das Wärmeübertragungselement durch verschieden tiefes Eintauchen in das Flüssigkeitsvolumen einen effektiven Wärmeaustausch zwischen Gas und Flüssigkeit. Das wird gewährleistet, indem das Wärmeübertragungselement in einer Einstellung möglichst vollständig außerhalb der Flüssigkeit positioniert ist und Wärme mit dem Gas austauscht und in einer weiteren Einstellung möglichst vollständig in der Flüssigkeit eingetaucht ist um mit dieser Wärme auszutauschen.

Mit dem Wärmeübertragungselement kann, je nach Konstruktion oder Betrieb des Wandlers, Wärme von der Flüssigkeit an das Gas übertragen werden (die Flüssigkeit erwärmt das Gas) oder Wärme von dem Gas an die Flüssigkeit (das Gas erwärmt die Flüssigkeit). Die Verbindung der beiden Primärvolumina umfasst vorzugsweise einen Regenerator.

In einer Ausführungsform ist die Vorrichtung dadurch gekennzeichnet, dass das Wärmeübertragungselement eine Oberfläche aufweist, die größer als die Oberfläche der das Gasvolumen begrenzenden Flächen ist (vorzugsweise doppelt so groß, bevorzugt 5 mal größer). Durch eine so große Oberfläche wird ein möglichst effektiver Austausch von Wärme zwischen Gas und Wärmeübertragungselement auf der einen Seite und Wärmeübertragungselement und Flüssigkeit auf der anderen Seite und damit zwischen Gas und Flüssigkeit erreicht. Das gestattet eine nahezu isotherme Prozessführung aufgrund des gleichmäßig in einem großen Teil des Gasvolumens stattfindenden Wärmeaustauschs zwischen Gas und Wärmeübertragungselement.

In einer weiteren Ausführungsform ist die Vorrichtung dadurch gekennzeichnet, dass das Wärmeübertragungselement entweder an der zum Flüssigkeitsvolumen weisenden Fläche des Volumenänderungselements befestigt ist oder fest an den das Primärvolumen begrenzenden Flächen vorgesehen ist. Durch eine Befestigung des Wärmeübertragungselements am beweglichen festen (weder flüssigen noch gasförmigen) Volumenänderungselement kann eine zusätzliche bewegliche Lagerung des Wärmeübertragungselements vermieden werden und es wird gleichzeitig erreicht, dass das vom Volumenänderungselement bewegte Gas stets durch das Wärmeübertragungselement erwärmt wird. Wird das Wärmeübertragungselement fest an den das Primärvolumen begrenzenden Flächen befestigt, so ergeben sich flexiblere Ausgestaltungsmöglichkeiten des Volumenänderungselements.

In einer weiteren Ausführungsform ist die Vorrichtung dadurch gekennzeichnet, dass das Wärmeübertragungselement entweder eine Vielzahl voneinander getrennter Platten, einer Vielzahl von getrennten Stäben, einer Vielzahl miteinander verbundener Gitter oder einen für Flüssigkeit und Gase durchlässigen Metallschaum umfasst. Diese Platten, Stäbe, das Gitter oder der Metallschaum weisen Zwischenräume auf, die in mindestens eine Richtung maximale Abmessungen von <20mm, vorzugsweise <10mm, bevorzugt <2mm haben. Das hat den Vorteil, dass ein guter Wärmeaustausch zwischen Flüssigkeit und Wärmeübertragungselement bzw. zwischen Gas und Wärmeübertragungselement ermöglicht wird. Auch Kombinationen dieser Möglichkeiten sind in dieser Ausführungsform denkbar. Vorzugsweise bestehen die Platten, die Stäbe und das Gitter aus gut wärmeleitendem Material, wie beispielsweise Metallen, wobei die Wärmeleitfähigkeit des Materials wenigstens bei

$$\lambda \geq 10 \frac{W}{m \cdot K}$$ liegt. Durch diese Ausgestaltung des Wärmeübertragungselements wird erreicht, dass das Wärmeübertragungselement beim Eintauchen in die Flüssigkeit einen möglichst kompletten Wärmeaustausch gewährleisten kann. Das wird erreicht indem ein großer Teil (mindestens 60%, vorzugsweise 80%, bevorzugt 90%) oder das gesamte, das Wärmeübertragungselement bildende Material Wärme mit der Flüssigkeit austauscht. Des Weiteren wird durch diese Ausgestaltung des Wärmeübertragungselements erreicht, dass dem Gas eine möglichst große Fläche zum Wärmeaustausch zur Verfügung steht.

In einer weiteren Ausführungsform ist die Vorrichtung dadurch gekennzeichnet, dass elektromagnetische Komponenten vorgesehen sind, die für eine Bewegung des Volumenänderungselements geeignet sind. Dadurch lassen sich Bewegungen des Volumenänderungselements erreichen, die von der Bewegung gemäß einer harmonischen Schwingung, wie sie bei bekannten mechanischen Kolben zum Einsatz kommt, abweichen kann. Insbesondere lassen sich dadurch Bewegungen mit einer definierten Amplitude erreichen, die anders als bei einer harmonischen Schwingung von der Geschwindigkeit des Volumenänderungselements beim Durchgang durch den Bewegungsmittelpunkt unabhängig ist.

In einer Ausführungsform ist die Vorrichtung dadurch gekennzeichnet, dass das Volumenänderungselement entweder einen verschiebbaren Kolben, einen Rotationskolben, eine bewegliche Membran, einen beweglichen Regenerator oder die Flüssigkeit selbst umfasst. Die Ausgestaltung des Volumenänderungselements mit Hilfe eines massiven Körpers erlaubt die direkte Verbindung des Volumenänderungselements mit Vorrichtungen zum Ausführen der Bewegung des Volumenänderungselements und eine Verbindung des Volumenänderungselements mit dem Wärmeübertragungselement, wodurch auf zusätzlich Motoren und bewegliche Komponenten verzichtet werden kann. Die Ausgestaltung des Volumenänderungselements mit Hilfe der vorgesehenen Flüssigkeit gestattet eine Volumenänderung des Arbeitsgases nur durch Anheben und Senken des Flüssigkeitsspiegels, wodurch eine sehr gleichmäßige und stoßfreie Volumenänderung gegeben ist und erlaubt ferner die Befestigung des Wärmeübertragungselements an den das Primärvolumen bildenden Begrenzungsflächen.

In einer weiteren Ausführungsform ist die Vorrichtung dadurch gekennzeichnet, dass an wenigstens einem Volumenänderungselement oder an den das Primärvolumen begrenzenden Flächen ein eventuell beweglicher Absorber vorgesehen ist, der elektromagnetische Strahlung in Wärme umformen und auf das Arbeitsgas übertragen kann. Dadurch kann vorzugsweise das Sonnenlicht zum Erwärmen des Arbeitsgases vorgesehen sein und so Sonnenenergie genutzt werden, um Volumenarbeit zu verrichten und einen Wärmeaustausch mit einer Flüssigkeit zu erreichen.

In einer weiteren Ausführungsform ist die Vorrichtung dadurch gekennzeichnet, dass die Vorrichtung entweder als Alpha-Stirlingmaschine, als Duplex-Alpha-Stirlingmaschine, als mehrfach wirkende Alpha-Stirlingmaschine, als Beta-/Gamma-Stirlingmaschine, als Duplex-Beta-/Gamma-Stirlingmaschine, als mehrfach wirkende Beta-/Gamma-Stirlingmaschine oder als Vuilleumiermaschine vorgesehen ist. Die Ausgestaltung der Vorrichtungen in einer dieser möglichen Ausführungsformen erlaubt einen flexiblen Einsatz in unterschiedlichsten Arbeitsbereichen. Duplex-Stirlingmaschinen sind Maschinen, die zwei Paare an mit Regeneratoren verbundenen Gasvolumina mit veränderlicher Größe haben. Mehrfach wirkende Stirlingmaschinen sind Maschinen, die mehr als zwei Paare an mit Regeneratoren verbundenen Gasvolumina mit veränderlicher Größe haben. Duplex- oder mehrfach wirkende Stirlingmaschinen bieten insbesondere die Möglichkeit, links- und rechtsläufige Stirlingprozesse miteinander zu kombinieren und so u.a. Wärmemengen mit gewissen Temperaturen in Wärmemengen mit gewissen anderen Temperaturen umzuformen.

In einer weiteren Ausführungsform ist die Vorrichtung dadurch gekennzeichnet, dass das Volumenänderungselement einen Rotationskolben umfasst, der entweder einen gasdurchlässigen Regenerator enthält oder gasundurchlässig ist, und der durch seine periodische Rotationsbewegung mit wechselnder Drehrichtung das Volumen zweier unterschiedlicher Gasvolumina ändern kann.

Unter Verwendung beispielsweise dieser Vorrichtung lässt sich ein Verfahren zur Umwandlung von Wärmemengen in elektrische Energie oder elektrische Energie in Wärmemengen oder Wärmemengen mit gewissen Temperaturen in Wärmemengen mit gewissen anderen Temperaturen mittels eines thermoelektrischen Wandlers verwirklichen, wobei das Verfahren dadurch gekennzeichnet ist, dass sich der Anteil eines Wärmeübertragungselements, der sich im Flüssigkeitsvolumen befindet, periodisch ändert. Durch dieses Verfahren kann ein effektiver Wärmeaustausch zwischen Arbeitsgas und Wärmeübertragungselement auf der einen Seite und Wärmeübertragungselement und Flüssigkeit auf der anderen Seite realisiert werden.

In einer Ausführungsform ist das Verfahren dadurch gekennzeichnet, dass sich permanent eine Flüssigkeit im Flüssigkeitsvolumen befindet. Da Mittel zur thermischen Kopplung der Flüssigkeit im Flüssigkeitsvolumen vorgesehen sind, kann so auf Mittel zur Ausleitung der Flüssigkeit aus dem Flüssigkeitsvolumen verzichtet werden. Alternativ kann auf Mittel zur thermischen Kopplung innerhalb der Primärvolumina verzichtet werden und beispielsweise durch Umwälzen oder Pumpen eine Ausleitung der Flüssigkeit erreicht werden und außerhalb der Primärvolumina ein Wärmeaustausch mit beispielsweise einem Kühlflüssigkeitskreislauf stattfinden oder aber die Flüssigkeit kann selbst zu einem Kühlmittelkreislauf von beispielsweise einem Verbrennungsmotor gehören.

In einer Ausführungsform ist das Verfahren dadurch gekennzeichnet, dass das Volumenänderungselement durch elektromagnetische Komponenten periodisch bewegt oder verformt wird. Das gestattet im Gegensatz zu üblichen mechanischen Kopplungen des Volumenänderungselements die Bewegung des Volumenänderungselements gemäß nicht harmonischer Bewegung.

In einer Ausführungsform ist das Verfahren dadurch gekennzeichnet, dass die Amplitude der Bewegung des Volumenänderungselements so gesteuert wird, dass die Geschwindigkeit des Volumenänderungselements beim Durchgang durch den Bewegungsmittelpunkt größer als die Geschwindigkeit einer harmonischen Schwingung gleicher Periodendauer ist. Bevorzugt ist die Geschwindigkeit 10% oder 20% größer als die der harmonischen Schwingung.

In einer weiteren Ausführungsform ist das Verfahren dadurch gekennzeichnet, dass die Volumenänderungselemente in den Primärvolumina so bewegt werden, dass sich während einer Kompressionsphase ein Vielfaches (mindestens das 4-fache, vorzugsweise mindestens das 8-fache, bevorzugt mindestens das 20-fache) des Arbeitsgases des ersten Primärvolumens im zweiten Primärvolumen befindet und während einer Expansionsphase sich ein Bruchteil (vorzugsweise 1/3, bevorzugt 1/8, vorzugsweise 1/10) des Arbeitsgases des ersten Primärvolumens im zweiten Primärvolumen befindet. Dadurch wird erreicht, dass sich nahezu das komplette Arbeitsgas im passenden Arbeitsbereich befindet und somit eine möglichst isotherme Prozessführung verwirklicht wird und Totraumvolumina minimiert wird.

In einer Ausführungsform ist das Verfahren dadurch gekennzeichnet, dass sich die Wärmeübertragungselemente relativ zu den das Primärvolumen bildenden Begrenzungsflächen bewegen lassen. Bevorzugt sind die Wärmeübertragungselemente dabei fest mit den Volumenänderungselementen verbunden, wodurch auf zusätzliche Antriebselemente für die Wärmeübertragungselemente verzichtet werden kann.

In einer Ausführungsform ist das Verfahren dadurch gekennzeichnet, dass die Volumenänderung des Gasvolumens durch Änderung des Anteils des Flüssigkeitsvolumens am Primärvolumen erfolgt. In diesem Fall dient die Flüssigkeit sowohl als Medium zum Wärmeaustausch mit dem Gas mit Hilfe der Wärmeübertragungselemente als auch gleichzeitig als Volumenänderungselement und macht somit den Einbau weiterer mechanischer Teile im Primärvolumen außerhalb des Flüssigkeitsvolumens vermeidbar und ermöglicht so ein größeres Primärvolumen.

## Kurzbeschreibung der Figuren

Fig. 1　　　Schematische Darstellung einer erfindungsgemäßen Vorrichtung als Alpha-Stirlingmaschine.

Fig. 2a-d　Schematische Darstellung eines kompletten Arbeitszyklus einer erfindungsgemäßen Vorrichtung.

Fig. 3　　　Schematische Darstellung einer erfindungsgemäßen Vorrichtung in einer Ausführungsform mit beweglicher Flüssigkeitssäule als Volumenänderungselement.

Fig. 4　　　Schematische Darstellung einer erfindungsgemäßen Vorrichtung in einer Ausführungsform als Duplex-Alpha-Maschine.

Fig. 5　　　Schematische Darstellung einer erfindungsgemäßen Vorrichtung in einer Ausführungsform als Duplex-Gamma-Stirlingmaschine.

Fig. 6　　　Schematische Darstellung einer erfindungsgemäßen Vorrichtung in einer Ausführungsform mit einem Rotationskolben.

## Detaillierte Figurenbeschreibung

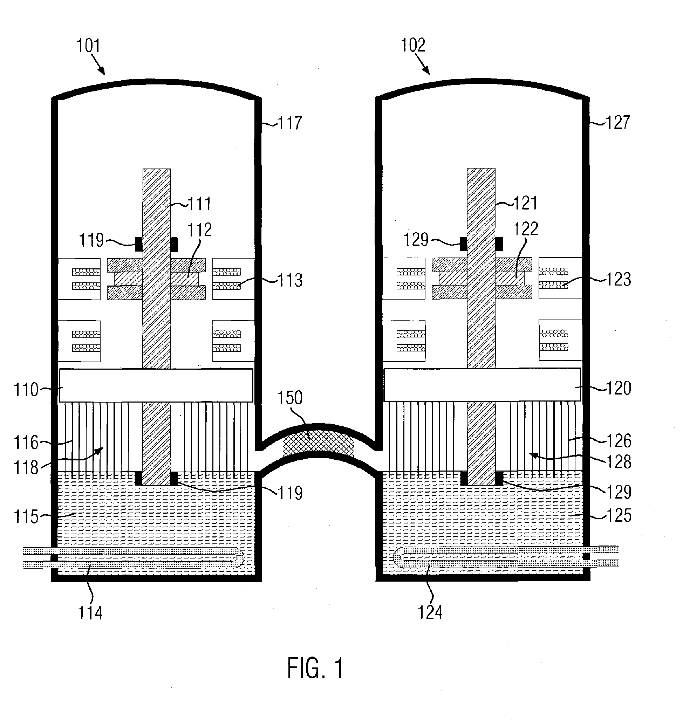

Fig. 1 zeigt eine Ausführungsform einer erfindungsgemäßen Vorrichtung als Alpha-Stirlingmaschine. Diese umfasst zwei Zylinder 101 und 102, die jeweils das Primärvolumen 117 bzw. 127 bilden. Eine Verbindung dieser beiden Primärvolumina 117 und 127 wird über das Verbindungselement 150 mit Regenerator verwirklicht. In den Primärvolumina sind Flüssigkeitsvolumina 115 bzw. 125 und Gasvolumina 118 bzw. 128 vorgesehen. Vorzugsweise befindet sich in dem Flüssigkeitsvolumen 115 bzw. 125 permanent eine Flüssigkeit. Des Weiteren ist ein Volumenänderungselement 110 in einem ersten Primärvolumen 117 und vorzugsweise ein weiteres Volumenänderungselement 120 im zweiten Primärvolumen 127 vorgesehen. An jedem dieser Volumenänderungselemente sind Wärmeübertragungselemente 116 bzw. 126 vorgesehen, die vorzugsweise aus Metall bestehen, aber insbesondere über eine sehr große Oberfläche und Wärmeleitfähigkeit verfügen. Die Volumenänderungselemente (beispielsweise Kolben) 110 und 120 sind ferner mit beispielsweise einer Kolbenstange 111 und 121 verbunden. An dieser Kolbenstange befinden sich vorzugsweise Permanentmagnete 112 bzw. 122, und sie wird von Gas - oder Gleit- bzw. hydrodynamischen Lagern 119 bzw. 129 geführt. Alternativ zu diesen Lagern ließe sich auch eine Lagerung der Kolben mittels verformbaren Elementen wie z.B. Federbändern oder Tellerfedern realisieren. Ferner sind an den das Primärvolumen 117 bzw. 127 begrenzenden Flächen Spulen 113 bzw. 123 vorgesehen. Durch das Zusammenspiel von Permanentmagnet 112 und Spulen 113 wird eine Bewegung des Volumenänderungselements 110 bewirkt bzw. gesteuert/geregelt. Dieses kann, wie in der Abbildung ersichtlich, zumindest senkrecht zur Begrenzungsfläche zwischen Gasvolumen 118 bzw. 128 und Flüssigkeitsvolumen 115 bzw. 125, respektive senkrecht zur Oberfläche der Flüssigkeit bewegt werden. Eine Ausgestaltung der für die Bewegung notwendigen Mechanismen muss nicht elektromagnetisch erfolgen, sondern kann auch über mechanische Verbindungen verwirklicht werden. Durch die Bewegung der Volumenänderungselemente 110 und 120 wird der Anteil der Wärmeübertragungselemente 116 bzw. 126, der sich innerhalb des Flüssigkeitsvolumens 115 bzw. 125 befindet, verändert. Da Wärmetauscher 114 und 124 in den Flüssigkeitsvolumina 115 und 125 vorgesehen sind, die zu einer thermischen Kopplung der jeweils in den Flüssigkeitsvolumina 115 und 125 befindlichen Flüssigkeit mit vorzugsweise außenliegenden Wärmereservoiren, Wärmequellen oder Wärmesenken vorgesehen sind, führt das Verändern des Anteils der Wärmeübertragungselemente 116 und 126, der sich im Flüssigkeitsvolumen 115 bzw. 125 befindet und damit in thermischem Kontakt mit den entsprechenden Flüssigkeiten zu einem Wärmeaustausch zwischen den Flüssigkeiten und den Wärmeübertragungselementen 116 und 126. Ferner kommt es durch die Bewegung der Wärmeübertragungselemente und der Volumenübertragungselementen 110 bzw. 120 zu einem Wärmeaustausch zwischen den Wärmeübertragungselementen 116 und 126 mit dem in den Gasvolumina 118 und 128 befindlichen Gas. Wird die Bewegung der Volumenänderungselemente 110 bzw. 120 in den Zylindern 101 und 102 passend durch beispielsweise eine Steuereinheit gesteuert, lässt sich bei unterschiedlicher Temperatur der Flüssigkeiten in den Flüssigkeitsvolumina 115 und 125 ein thermodynamischer Kreisprozess realisieren.

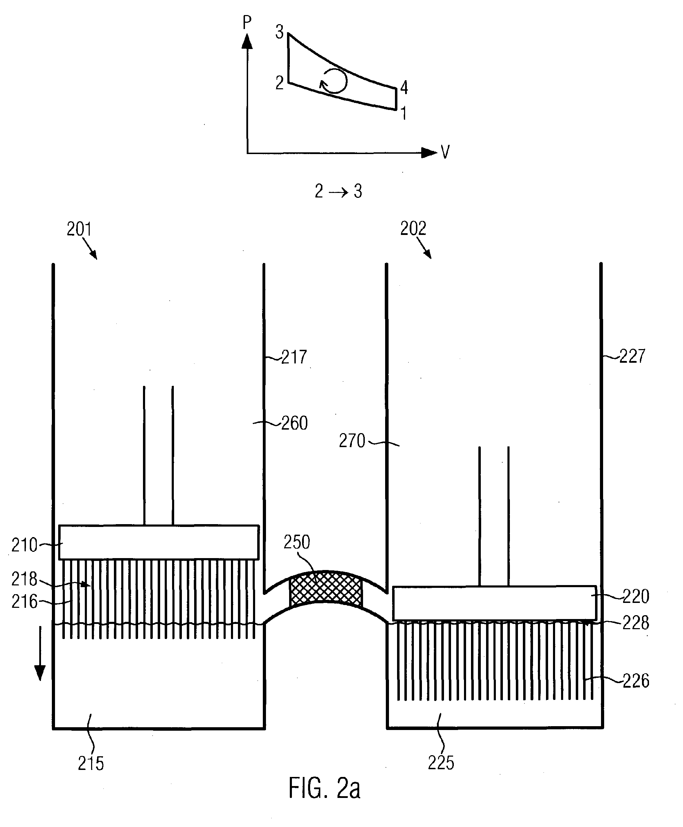

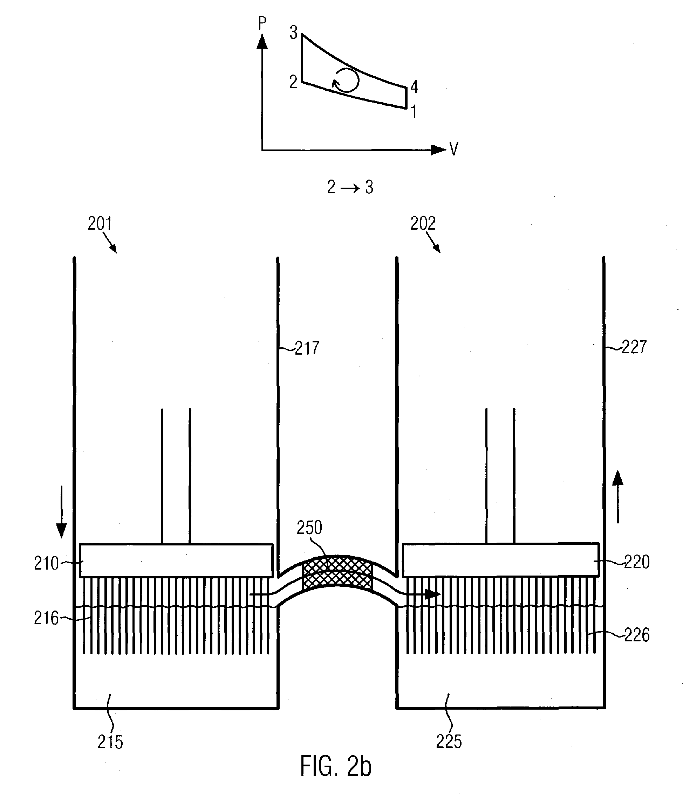

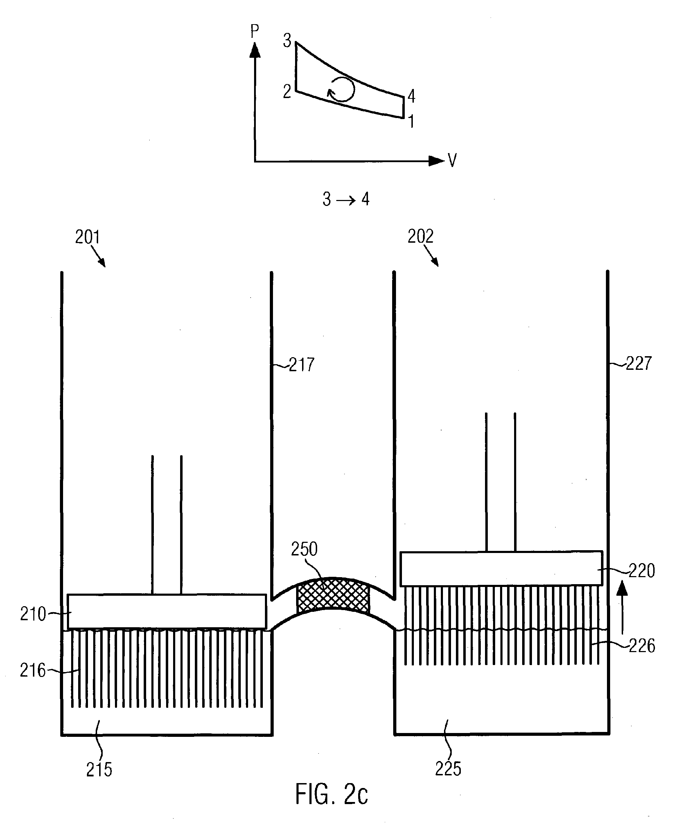

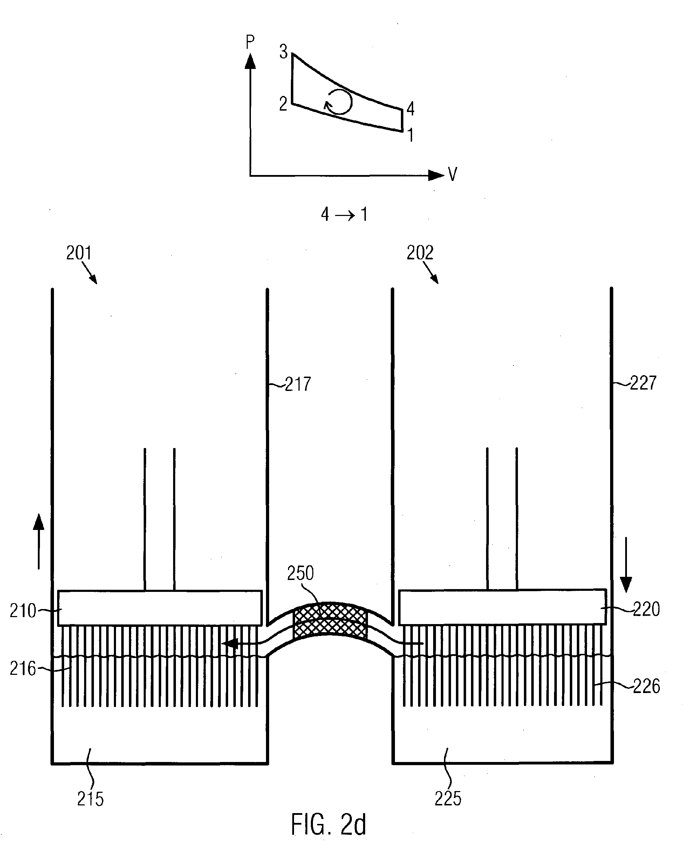

Fig. 2 a-d zeigt eine mögliche Realisierung eines thermodynamischen Kreisprozesses mit dem erfindungsgemäßen thermoelektrischen Wandler im Sinne eines rechtsläufigen Kreisprozesses. Rechtsläufige Kreisprozesse realisieren in der Thermodynamik bekanntermaßen Wärmekraftmaschinen, die zugeführte Wärme in Arbeit umwandeln. In Fig. 2a-2d ist jeweils das entsprechende pV-Diagramm eines rechtsläufigen Kreisprozesses bestehend aus zwei isothermen und zwei isochoren Zustandsänderungen dargestellt. Die folgenden Erklärungen gehen vereinfachend davon aus, dass die Prozessführung ideal erfolgt, das bedeutet, dass die Zustandsänderungen des Gases infinitesimal ablaufen und das Prozessgas während jeder Zustandsänderung als ideales Gas beschrieben werden kann und ferner die Zustandsänderungen idealen Isothermen und Isochoren entsprechen. Die in Fig. 2a-d dargestellten Zylinder 201 und 202 sind zur besseren Übersichtlichkeit sehr vereinfachend dargestellt. Zur vollständigen Realisierung des beschriebenen Prozesses würden sie beispielsweise wenigstens weitere oder sämtliche Bestandteile der Zylinder in Fig. 1 umfassen müssen.

Fig. 2a beschreibt die Abläufe in den Zylindern 201 und 202 während der Zustandsänderung von Zustand 1, beschrieben durch die Temperatur $T_0$, den Druck $p_1$ und das Volumen $V_1$ auf Zustand 2, beschrieben durch die Temperatur $T_0$, den Druck $p_2$ und das Volumen $V_2$. Bei dieser Zustandsänderung handelt es sich um eine isotherme Kompression, bei der das Volumen des Arbeitsgases verringert und bei gleichbleibender Temperatur (Änderung der inneren Energie $dU = 0$) der Druck des Gases erhöht wird. Dazu befindet sich der Kolben 220 im Zylinder 202 in Ruhe vorzugsweise in einer Position, in der kein Gas aus Zylinder 201 über das Verbindungselement 250 in den Zylinder 202 strömen kann. Gleichzeitig wird der Kolben 210 im ersten Zylinder 201 in Richtung Flüssigkeitsvolumen und Flüssigkeit 215 bewegt. Damit die Temperatur konstant bleibt, ist vorgesehen, dass die Flüssigkeit und insbesondere die Wärmeübertragungselemente 216 eine geringere Temperatur als das Arbeitsgas aufweisen. So wird erreicht, dass das Arbeitsgas während der Kompression Wärme an die Wärmeübertragungselemente 216 abgeben kann. Sobald die Wärmeübertragungselemente 216 mit der Flüssigkeit im Flüssigkeitsvolumen 215 in Verbindung stehen, wird diese Wärme an die Flüssigkeit abgegeben, die über die thermische Kopplung mit dem externen Wärmereservoir die zugeführte Wärme an das Wärmereservoir abgibt. Zur Kompression des Gases während der isothermen Kompression von Zustand 1 auf Zustand 2 wird eine Arbeit $\Delta W$ vom Kolben 210 bzw. von den diesen Kolben 210 bewegenden vorzugsweise elektromagnetischen Komponenten, und gegebenenfalls zusätzlich durch den Druck des sich oberhalb des Kolbens 210 befindlichen Gasvolumens 260, am Gas verrichtet. Läuft dieser Prozess hinreichend langsam ab, kann ein vollständiger Wärmeaustausch des Gases mit den Wärmeübertragungselementen 216 und der Flüssigkeit 215 realisiert werden, so dass eine vollständige Umwandlung der am Gas verrichteten Arbeit $\Delta W$ in Wärme $\Delta Q$ möglich ist. Am Ende der Zustandsänderung hat das Gas den Zustand 2 erreicht, in dem es durch die Temperatur $T_0$, den Druck $p_2$ und das Volumen $V_2$ beschrieben wird.

Fig. 2b zeigt die Zustandsänderung von Zustand 2 auf Zustand 3, beschrieben durch die Temperatur $T_1$, den Druck $p_3$ und das Volumen $V_2$, bei der es sich um eine isochore Erwärmung handelt. Dabei wird der Kolben 220 in Zylinder 202 genau so weit nach oben bewegt, wie der Kolben 210 im Zylinder 201 nach unten bewegt wird. Dadurch strömt Gas aus dem Zylinder 201 durch das Verbindungselement 250 mit dem Regenerator in den Zylinder 202. Die Flüssigkeit im Zylinder 202 im Flüssigkeitsvolumen 225 besitzt dabei eine höhere Temperatur $T_1$. Der Kontakt des Arbeitsgases mit den Wärmeübertragungselementen 226 und der Flüssigkeit 225 an deren Oberfläche führen insbesondere aufgrund der großen Oberfläche der Wärmeübertragungselemente 226 dazu, dass das Arbeitsgas von seiner Temperatur $T_0$ durch Wärmeaufnahme bei hinreichend langsamer Prozessführung (Verschiebung der Kolben 210 und 220) auf die Temperatur $T_1$ erwärmt wird. Da sich das zur Verfügung stehende Gasvolumen im Zylinder 202 durch Aufwärtsbewegen des Kolbens 220 genau so weit vergrößert, wie sich das im Zylinder 201 zur Verfügung stehende Gasvolumen durch Herabbewegen des Kolbens 210 verringert, ändert sich das dem Gas zur Verfügung stehende Volumen nicht und es wird daher keine Arbeit verrichtet. Am Ende dieser Zustandsänderung befindet sich der Kolben 210 im Zylinder 201 in einer Position, in der vorzugsweise sämtliches Gas aus dem Zylinder 201 verdrängt ist, die Wärmeübertragungselemente 216 zum Wärmeaustausch mit der Flüssigkeit 215 nahezu vollständig im Flüssigkeitsvolumen 215 eingetaucht sind und evtl. die Verbindung 250 verschlossen wurde, so dass kein Gas zurückströmen kann. Das Gas wird dann durch die Temperatur $T_1$, den Druck $p_3$ und das Volumen $V_2$ beschrieben. Während des Übergangs des Gases von Zylinder 201 in Zylinder 202 hat es den Regenerator im Verbindungselement 250 passiert und die in diesem Regenerator aus dem vorherigen Arbeitszyklus gespeicherte Wärme aufgenommen. Gleichzeitig ist aufgrund der großen Oberfläche der Wärmeübertragungselemente 226 viel Wärme an das Gas beim Übertritt in den Zylinder 202 übertragen worden.

Fig. 2c zeigt eine Zustandsänderung von Zustand 3 auf Zustand 4, beschrieben durch die Temperatur $T_1$, den Druck $p_4$ und das Volumen $V_4$, bei der es sich um eine isotherme Expansion handelt. Da das Gas weiterhin Wärme aus den Wärmeübertragungselementen 226 und der Oberfläche der Flüssigkeit im Flüssigkeitsvolumen 225 aufnimmt, gleichzeitig aber der Kolben nicht festgestellt ist (dazu werden vorzugsweise die Spulen, die für die Bewegung durch elektromagnetische Kräfte verantwortlich sind, so geschaltet, dass sie die vom Gas am Kolbens 220 verrichtete Arbeit in elektrische Energie umwandeln), verrichtet das Gas durch Anheben des Kolbens 220 Arbeit. Läuft dieser Prozess hinreichend langsam ab, so verrichtet das Gas genau so viel Arbeit am Kolben 210, wie es Wärme aus den Wärmeübertragungselementen 226 und der Flüssigkeit im Flüssigkeitsvolumen 225 aufnimmt. Aufgrund der großen Oberfläche der Wärmeübertragungselemente 226 kann der Prozess real immer noch mit im Vergleich zu gängigen Vorrichtungen hoher Geschwindigkeit ablaufen und gleichzeitig eine möglichst ideale isotherme Zustandsänderung erreicht werden, da der Wärmeaustausch zwischen Gas und Wärmeübertragungselement 226 sehr effektiv ist. Durch das Anheben des Kolbens verrichtet das Gas bei der Temperatur $T_1$ Arbeit am Kolben 220 und leistet somit Volumenarbeit.

Fig. 2d zeigt die Zustandsänderung von Zustand 4 auf Zustand 1, bei der es sich um eine isochore Abkühlung handelt. Dabei wird der Kolben 210 im Zylinder 201 wieder nach oben bewegt, wodurch Gas aus dem Kolben 202 in Zylinder 201 über die Verbindung 250 mit dem Regenerator strömt. Gleichzeitig wird der Kolben 220 im Zylinder 202 nach unten bewegt. Das Gas gibt beim Übergang vom Zylinder 202 in Zylinder 201 Wärme an den Regenerator im Verbindungselement 250 ab und verringert dadurch seine Temperatur. Des Weiteren gibt es Wärme an die Wärmeübertragungselemente 216 und die Oberfläche der Flüssigkeit im Flüssigkeitsvolumen 215 im Zylinder 201 ab, wodurch es sich weiterhin abkühlt. Dadurch verringert sich der Druck auf die Kolben 210 bzw. 220, weil das Volumen konstant gehalten wird und dadurch die Abgabe von Wärme an die Wärmeübertragungselemente 216 und die Flüssigkeit im Flüssigkeitsvolumen 215 und den Regenerator im Verbindungselement 250 in einer Änderung der inneren Energie des Gases resultiert. Das Gas hat so wieder den Ausgangszustand 1, gekennzeichnet durch die Temperatur $T_0$, den Druck $p_1$ und das Volumen $V_1$, erreicht. Durch die Wärmeübertragungselemente 216 und 226 ist ein sehr effektiver Austausch von Wärme aufgrund ihrer sehr großen Fläche sowohl mit der Flüssigkeit in den Flüssigkeitsvolumina 215 und 225 als auch mit dem Arbeitsgas möglich. Damit lässt sich eine Prozessführung erreichen, die in realer Umsetzung wesentlich näher an die idealen isochoren und isothermen Zustandsänderungen heranreicht als das bei gängigen Vorrichtungen ohne Wärmeübertragungselemente bzw. ohne Flüssigkeit der Fall ist und somit ein erheblich höherer Wirkungsgrad erzielen.

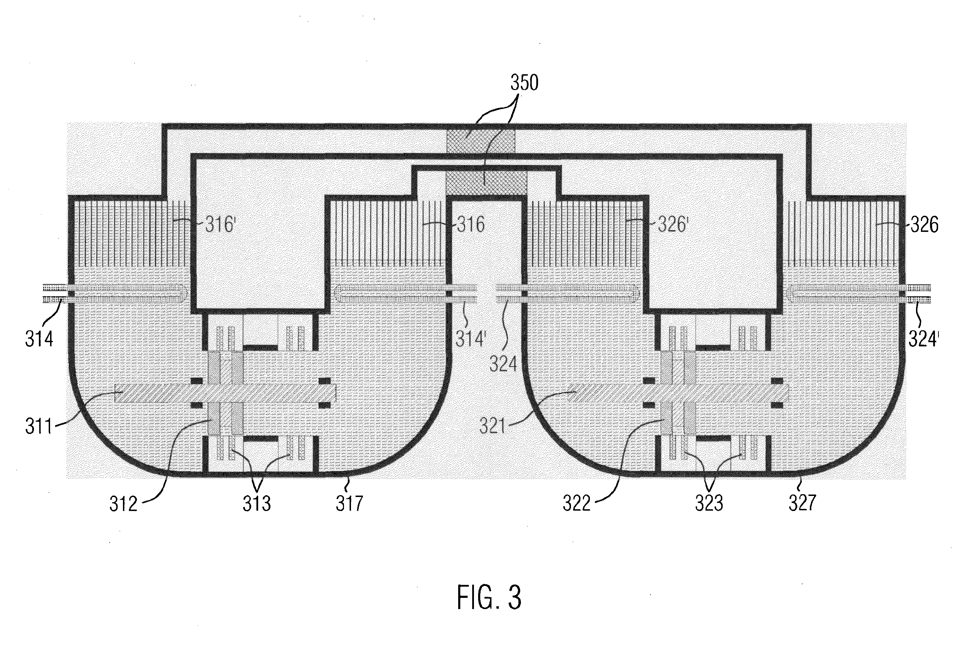

Fig. 3 zeigt eine erfindungsgemäße Ausführungsform, bei der kein festes Volumenänderungselement zur Änderung des Gasvolumens vorgesehen ist, sondern die Änderung der zur Verfügung stehenden Gasvolumina durch Änderung des Flüssigkeitsstandes bewirkt wird. Gleichzeitig sind die Wärmeübertragungselemente 316, 316' und 326 und 326' so angeordnet, dass sie bei Änderung des Flüssigkeitsstandes unterschiedlich stark in die Flüssigkeit eintauchen. In dieser Ausführungsform sind zwei Verbindungselemente 350 mit jeweils einem Regenerator vorgesehen. Ferner sind in den Primärvolumina 317 und 327 zwei voneinander getrennte Bereiche vorgesehen, die über einzelne Wärmetauscher 314, 314' und 324 und 324' an Wärmereservoire, -quellen, oder -senken thermisch gekoppelt sind. In jedem der Primärvolumina 317 und 327 ist außerdem die bereits bekannte Anordnung zur Volumenänderung aus Fig. 1 vorgesehen. Diese umfasst zunächst eine Kolbenstange 311 bzw. 321, die über hydrodynamische Lager magnetische Kräfte zwischen Permanentmagneten und um die Spulen 313 bzw. 323 angeordnete ferromagnetische Komponenten eine Verschiebung des Permanentmagneten 312 bzw. 322 über ein gewisses Maximum hinaus verhindert. Der Permanentmagnet 312 bzw. 322 ist zwischen den Spulen 313 bzw. 323 so angeordnet, dass kein oder nur ein sehr geringer Flüssigkeitsaustausch zwischen den einzelnen Bereichen jedes Primärvolumens 317 und 327 auftritt. Dadurch wird gewährleistet, dass sich in der gegebenen Form der Primärvolumina 317 und 327 gemäß einer U-Form, ungeachtet der Drücke der darüber befindlichen Gase, die sich aufgrund der sich in unterschiedlichen Zustände gemäß Fig. 2 ergeben, unterschiedliche Flüssigkeitsspiegel erreichen lassen. Wird der Permanentmagnet 312 bzw. 322 durch die Spulen 313 bzw. 323 bewegt, ändert sich der Stand der Flüssigkeiten und somit kann entweder vom Arbeitsgas oder am Arbeitsgas Arbeit durch Änderung des zur Verfügung stehenden Volumens verrichtet werden. Dabei läuft ein vollständiger Arbeitszyklus jeweils über die an eines der Verbindungselemente 350 verbundenen Teile der Primärvolumina 317 und 327 ab. Daraus ergibt sich beispielsweise, dass die ablaufenden Zustandsänderungen jeweils um 180° versetzt sind. Das bedeutet beispielsweise, dass wenn eines der Arbeitsgase isotherm komprimiert wird, das andere Arbeitsgas eine isotherme Expansion durchläuft. Selbiges gilt für die isochoren Zustandsänderungen.

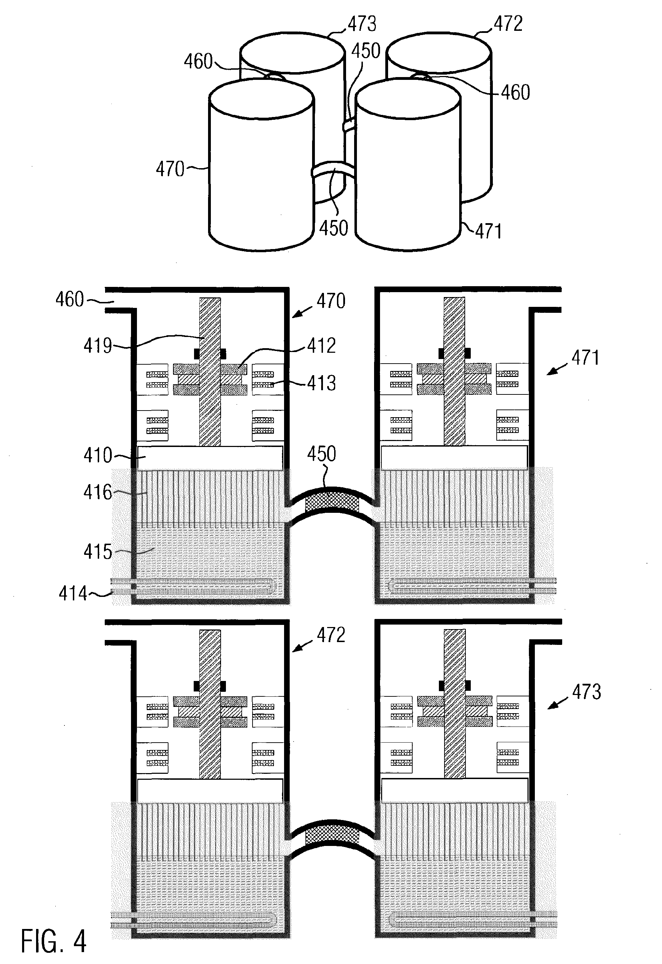

Fig. 4 zeigt eine erfindungsgemäße Vorrichtung in einer Ausführungsform gemäß einer Duplex-Alpha-Stirlingmaschine. Dabei sind vier Zylinder 470, 471, 472 und 473 vorgesehen. Jeder dieser Zylinder umfasst alle Elemente, die auch in den Zylindern 101 bzw. 102 in Fig. 1 vorgesehen sind. Darüber hinaus sind zwei Zylinder mit Verbindungselementen 450 und zwei Zylinder mit Öffnungen 460 verbunden. Dabei ist die Verbindung derart vorgesehen, dass die Zylinder, die über Verbindungselemente 450 miteinander verbunden sind, nicht über Verbindungselemente 460 miteinander verbunden sind und die Zylinder, die über Verbindungselemente 460 miteinander verbunden sind, nicht über Verbindungselemente 450 miteinander verbunden sind. Gemäß Fig. 3 ergibt sich daraus, dass die Zylinder 470 und 471 untereinander über Verbindungselemente 450 mit Regenerator miteinander verbunden sind, genauso wie die Zylinder 472 und 473. Die Zylinder 470 und 473 bzw. 471 und 472 sind nicht über solche Verbindungselemente 450 miteinander verbunden sondern über Verbindungselemente 460 ohne Regenerator. Die Verbindungselemente 450 mit dem Regenerator übernehmen dieselbe Aufgabe wie in Fig. 1 bzw. in Fig. 2a-d beschrieben. Die Verbindungselemente 460 sind gasdurchlässig und gewährleisten einen notwendigen Druckausgleich. Ist die Vorrichtung in Betrieb, so beträgt die Phasenverschiebung der in den Zylindern 470 und 471 ablaufenden Prozesse ca. 180° zu den in den Zylindern 472 und 473 ablaufenden Prozessen. Das bedeutet, befindet sich das Arbeitsgas der Zylinder 470 und 471 in der isothermen Kompression, befindet sich das Arbeitsgas der Zylinder 472 und 473 in der isothermen Expansion. Diese Anordnung kann genutzt werden, um entweder die Temperaturdifferenz zwischen zwei von außen anliegenden Wärmereservoiren zu nutzen, um eine entsprechende Temperaturdifferenz in den beiden anderen Wärmereservoiren zu erreichen oder um die von außen gegebenen Temperaturdifferenzen der Wärmereservoire in elektrische Energie umzuformen oder um elektrische Energie zu nutzen, um Temperaturdifferenzen in den anliegenden Wärmereservoiren zu generieren. Vorzugsweise umfassen die Wärmereservoire 414 in der ersten und letzten Alternative Flüssigkeitsströmungen, in die so Temperaturdifferenzen übertragen oder in denen so Temperaturdifferenzen erzeugt werden. Um die Mengen bzw. Verhältnisse der zum Antrieb der Vorrichtung genutzten Wärmemengen oder elektrischen Energie sowie der erzeugten Wärmemengen und elektrischen Energie zu verändern, kann die Phasenverschiebung der in den Zylindern ablaufenden Prozesse von 180° abweichend eingestellt werden, und/oder es kann die in Fig. 2 dargestellte Bewegung der Kolben relativ zueinander phasenverschoben werden.

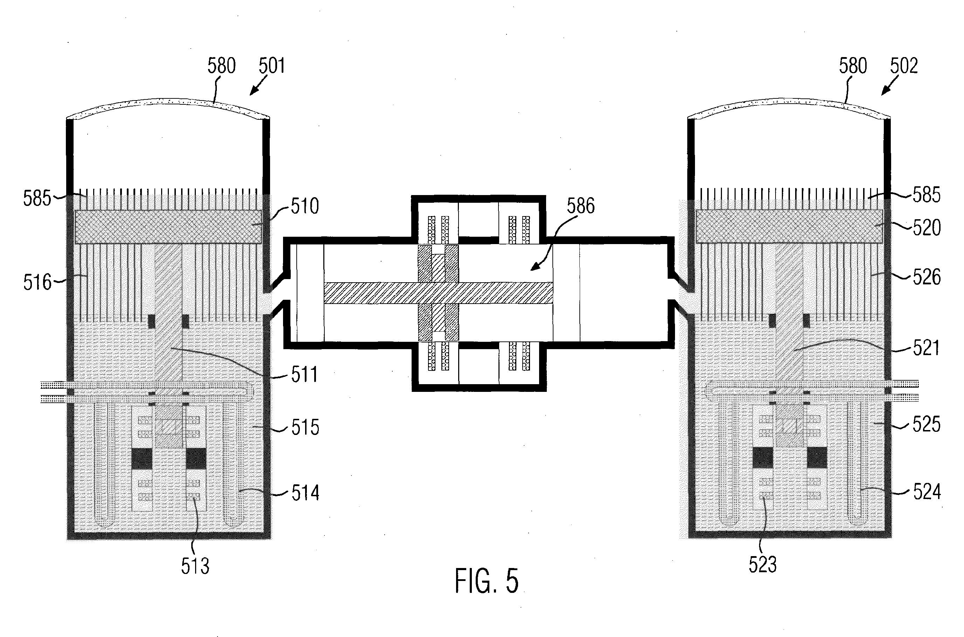

Fig. 5 zeigt eine erfindungsgemäße Vorrichtung in einer Ausführungsform als Duplex-Gamma-Stirlingmaschine, wobei hier die Volumenänderungselemente 510 bzw. 520 gleichzeitig die Funktion der Regeneratoren übernehmen. Die Volumenänderungselemente 510 und 520 sind hier daher gasdurchlässig konzipiert, und verändern sowohl die Größe der oberhalb von ihnen angeordneten Primärvolumina, als auch die Größe der unterhalb von ihnen angeordneten Primärvolumina. In dieser Ausführungsform enthalten nur die Primärvolumina unterhalb der Volumenänderungselemente ein Flüssigkeitsvolumen. Oberhalb der Volumenänderungselemente 510 und 520 sind Absorber 585 zum Absorbieren von elektromagnetischer Strahlung angebracht. Unterhalb des Volumenänderungselements 510 bzw. 520 sind in Richtung des Flüssigkeitsvolumens 515 bzw. 525 Wärmeübertragungselemente 516 bzw. 526 vorgesehen. Die Vorrichtung zum Bewegen der Volumenänderungselemente 510 bzw. 520, die die Kolbenstange 511 bzw. 521 und die Spulen 513 bzw. 523 sowie die Permanentmagneten 512 und 522 umfasst, ist vorzugsweise im Flüssigkeitsvolumen 515 bzw. 525 zusammen mit den Wärmetauschern oder Leitungen 514 und 524 zu externen Wärmereservoiren, -quellen oder -senken untergebracht. Ferner ist der Deckel 580 jedes Zylinders 501 und 502 für einen Wellenlängenbereich elektromagnetischer Strahlung, vorzugsweise für den gesamten Spektralbereich des Sonnenlichts, durchlässig. Darüber hinaus ist ein doppelt wirkender Arbeitskolben 586 als Verbindung zwischen den Zylindern 501 und 502 vorgesehen. Der Absorber 585 gibt die aufgenommene Energie der einfallenden elektromagnetischen Strahlung an das ihn umströmende, aus dem Regenerator 510 bzw. 520 kommende Arbeitsgas ab und erwärmt es damit. Nach dem Rückströmen des Gases durch den Regenerator 510 bzw. 520 kann es Wärme an die Wärmeübertragungselemente 516 und 526 abgeben, die diese Wärme wiederum durch ihre Bewegung in das Flüssigkeitsvolumen mit der Flüssigkeit 515 bzw. 525 durch Wärmeaustausch abgeben. Die von der Flüssigkeit aufgenommene Wärme wird dann an die Wärmereservoire über eine Weiterleitung durch die Wärmetauscher 514 bzw. 524 übertragen. Da es durch das Aufwärmen und Abkühlen wenigstens eines Teils des Arbeitgases in den Zylindern 501 und 502 zu Druckschwankungen kommen kann, ist der doppelt wirkende Arbeitskolben 586 vorgesehen, der die aus den Druckschwankungen resultierende Volumenarbeit des Arbeitsgases in elektrische Energie umwandeln kann. Dazu ist er vorzugsweise in einem eigenen Zylinder vorgesehen. Dieser Zylinder kann zur Umwandlung der geleisteten Volumenarbeit in elektrische Energie mehrere Spulen und einen oder mehrere Permanentmagnete am Arbeitskolben umfassen. Ebenso kann aber auch zweckmäßig eine Übertragung der Volumenarbeit durch den Arbeitskolben 586 mit Hilfe direkter mechanischer Verbindungen, z.B. mit einer Achse, erreicht werden. Fig. 5 zeigt ein Schnittbild, das sich z. B. in einer Bauform mit kreisförmiger Grundfläche der Primärvolumina realisieren lässt oder in einer anderen Bauform mit z.B. rechteckförmigem Querschnitt. Letztere ließe sich direkt unter einer länglichen Fresnel-Linse oder in einem Parabolrinnenspiegel anordnen.

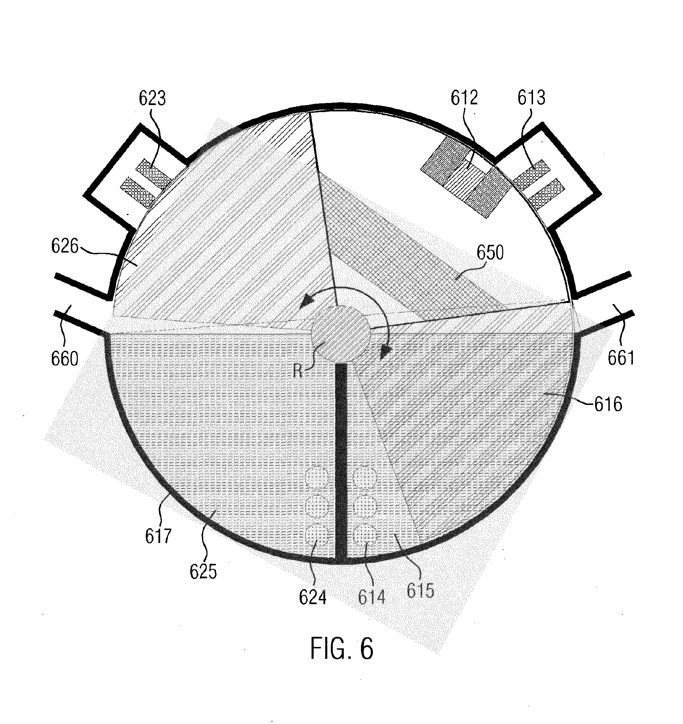

Fig. 6 zeigt eine erfindungsgemäße Vorrichtung unter Verwendung eines Rotationskolbens, der um eine Rotationsachse R rotieren kann. Dessen Rotation wird vorzugsweise ebenfalls über elektromagnetische Komponenten, insbesondere einen Permanentmagneten 612 und Spulen 613 und 623 erreicht. Der Rotationskolben ist in vier Segmente unterteilt. In einem Segment befindet sich vorzugsweise der Permanentmagnet 612 und ein Regenerator 650, wobei dieses Segment zumindest im Bereich des Regenerators gasdurchlässig vorgesehen ist. In den zwei an dieses Segment angrenzenden Segmenten 616 und 626 befinden sich die Wärmeübertragungselemente, die hier als parallel zueinander und orthogonal zur Rotationsachse angeordnete Metallplatten realisiert sind. Das vierte Segment besitzt keine weiteren massiven Bestandteile. Der Rotationskolben befindet sich in einem einen kreisrunden Querschnitt aufweisenden Behälter 617. Dieser kann als dreidimensional ausgedehnter Körper vorzugsweise ein Zylinder sein. Zusätzlich sind Gaszufuhrleitungen 660 und 661 vorgesehen. Weiterhin ist die Rotationsachse R des Rotationskolbens so positioniert, dass sie konzentrisch durch den Zylinder verläuft und gleichzeitig in der den Flüssigkeitsspiegel der Flüssigkeiten 615 und 625 bildenden Ebene liegt.

In den Flüssigkeitsvolumina 615 und 625 sind ferner Wärmetauscher oder Leitungen 614 und 624 zur thermischen Kopplung der Flüssigkeit in den Flüssigkeitsvolumina 615 und 625 mit den externen Wärmereservoiren, -quellen oder -senken vorgesehen. Die Begrenzungen der einzelnen Segmente gehen vorzugsweise orthogonal von der Rotationsachse aus.

Durch oszillierende Rotation des Rotationszylinders um die Rotationsachse R wird so erreicht, dass die Wärmeübertragungselemente 616 und 626 abwechselnd in die Flüssigkeitsvolumina 615 und 625 eintauchen und gleichzeitig das durch die Zuführung 660 und 661 transportierte Gas zwischen den Segmenten mit den Wärmeübertragungselementen 616 und 626 und dem Segment mit dem Regenerator 650 bewegt wird und auf diese Weise durch Wärmeübertragung ein entsprechender Kreisprozess realisiert werden kann.

Ist vorgesehen, dass die dargestellte Vorrichtung in Verbindung mit einer Gamma-Stirlingmaschine verwendet wird, so ist eine der Öffnungen 660 oder 661 verschlossen und die andere Öffnung führt zu einem Arbeitskolben, der insbesondere auch als Rotationskolben oder in einer anderen der beschriebenen Ausführungsformen oder in einer anderen Realisierung als Arbeitskolben, vorliegt. Alternativ ist es auch möglich, die Anordnung mit einer weiteren, baugleichen Anordnung zu verbinden und so eine Vuilleumiermaschine zu verwirklichen. Ferner ist es denkbar, durch Verbindung mit einem doppelt wirkenden Arbeitskolben, wie in Fig. 5 beschrieben und zweier Vorrichtungen mit Rotationskolben, eine Duplex-Stirlingmaschine zu verwirklichen. Weiterhin ist denkbar, den Rotationskolben ohne Regenerator, d.h. nicht gasdurchlässig zu realisieren, und so eine Duplex-Alpha-Stirlingmaschine mit zwei solchen Rotationskolben zu realisieren.

Es ist vorteilhaft, dass bis auf die in Fig. 5 dargestellte Ausführungsform alle beschriebenen erfindungsgemäßen Ausführungsformen sowohl für die Realisierung eines rechtsläufigen als auch linksläufigen thermodynamischen Kreisprozesses geeignet sind. Das erlaubt, nur durch geringe bauliche Veränderungen, eine Nutzung der Maschine sowohl als Wärmekraftmaschine (zur Umwandlung von Wärmemengen in elektrische Energie) als auch als Wärmepumpe (zur Umwandlung elektrischer Energie in Wärmemengen). Ferner kann jede der Ausführungsformen, bis auf die in Fig. 5 beschriebene, unter sehr hohem Druck verwendet werden. Um einen Gasverlust über die die Arbeitsgasvolumina begrenzenden Behälter (z.B. durch Diffusion) zu vermeiden, können die Behälter bzw. Primärvolumina mit einem zusätzlichen Druckbehälter umgeben werden, der mit einem Gas unter ähnlich hohem Druck befüllt ist, das weniger leicht durch diesen äußeren Druckbehälter diffundiert oder austritt. So tritt keine große Druckdifferenz mehr über die Grenzen der Primärvolumina hinweg auf, und die Diffusion des Arbeitsgases aus dem Primärvolumen hinaus wird so deutlich eingeschränkt.

**Patentansprüche**

1. Thermoelektrischer Wandler zur Umwandlung von Wärmemengen in elektrische Energie oder elektrischer Energie in Wärmemengen oder Wärmemengen mit gewissen Temperaturen in Wärmemengen mit gewissen anderen Temperaturen, der wenigstens zwei durch mindestens ein Verbindungselement miteinander verbundene Primärvolumina umfasst, die jeweils ein Gasvolumen umfassen, das für die Aufnahme von Gas geeignet ist und wobei mindestens eines der Primärvolumina oder beide ein Flüssigkeitsvolumen umfassen, das für die Aufnahme einer Flüssigkeit geeignet ist, wobei die Flüssigkeit thermisch an ein externes Wärmereservoir oder eine externe Wärmequelle oder eine externe Wärmesenke koppelbar ist, und wobei mindestens ein Volumenänderungselement in wenigstens einem der Primärvolumina zur Änderung der Größe des Gasvolumens vorgesehen ist, **dadurch gekennzeichnet, dass** ein Wärmeübertragungselement in wenigstens einem der Primärvolumina vorgesehen ist, wobei der Anteil des Wärmeübertragungselements, der sich im Flüssigkeitsvolumen befindet, variabel ist.

2. Vorrichtung aus Anspruch 1, **dadurch gekennzeichnet, dass** das Wärmeübertragungselement eine Oberfläche aufweist, die größer ist, als die Oberfläche der das Gasvolumen begrenzenden Flächen.

3. Vorrichtung aus Anspruch 1 oder 2, **dadurch gekennzeichnet, dass** das Wärmeübertragungselement entweder an der zum Flüssigkeitsvolumen weisenden Fläche des Volumenänderungselements befestigt ist, oder fest an den das Primärvolumen begrenzenden Flächen vorgesehen ist.

4. Vorrichtung aus einem der Ansprüche 1 bis 3, **dadurch gekennzeichnet, dass** das Wärmeübertragungselement wenigstens umfasst:

   eine Vielzahl voneinander getrennter Platten, bestehend aus gut wärmeleitendem Material wie beispielsweise Metalle;
   eine Vielzahl von getrennten Stäben, bestehend aus gut wärmeleitendem Material wie beispielsweise Metalle;
   einen für Flüssigkeiten und Gase durchlässigen Metall-Schaum;
   eine Vielzahl miteinander verbundener Gitter, bestehend aus gut wärmeleitendem Material wie beispielsweise Metalle;
   einer Anordnung aus gut wärmeleitendem Material mit Zwischenräumen, deren Abmessung in mindestens eine Richtung <20mm beträgt, vorzugsweise <10mm, bevorzugt <2mm.

5. Vorrichtung aus einem der Ansprüche 1 bis 4, **dadurch gekennzeichnet, dass** elektromagnetische Komponenten vorgesehen sind, die für eine Bewegung des Volumenänderungselements geeignet sind.

6. Vorrichtung aus einem der Ansprüche 1 bis 5, **dadurch gekennzeichnet, dass** das Volumenänderungselement eines von:

   ein verschiebbarer Kolben,
   ein Rotationskolben,
   eine bewegliche Membran,
   ein beweglicher Regenerator,
   die Flüssigkeit
   ist.

7. Vorrichtung aus einem der Ansprüche 1 bis 6, **dadurch gekennzeichnet, dass** an wenigstens einem Volumenänderungselement oder denen das Primärvolumen begrenzenden Flächen ein eventuell beweglicher Absorber vorgesehen ist, der elektromagnetische Strahlung in Wärme umformen und auf das Arbeitsgas übertragen kann.

8. Vorrichtung aus einem der Ansprüche 1 bis 7, **dadurch gekennzeichnet, dass** die Vorrichtung eines von:

   eine Alpha-Stirlingmaschine,
   eine Duplex-Alpha-Stirlingmaschine,
   eine mehrfach wirkende Alpha-Stirlingmaschine,
   eine Gamma- oder Beta-Stirlingmaschine,
   eine Duplex-Gamma- oder Duplex-Beta-Stirlingmaschine,
   eine mehrfach wirkende Gamma- oder Beta-Stirlingmaschine,
   eine Vuilleumiermaschine
   ist.

9. Verfahren zur Umwandlung von Wärmemengen in elektrische Energie oder elektrischer Energie in Wärmemengen oder Wärmemengen mit gewissen Temperaturen in Wärmemengen mit gewissen anderen Temperaturen, mittels eines thermoelektrischen Wandlers, der wenigstens zwei durch mindestens ein Verbindungselement miteinander verbundene Primärvolumina umfasst, die jeweils ein Gasvolumen mit einem Arbeitsgas umfassen und wobei mindestens eines der Primärvolumina oder beide ein Flüssigkeitsvolumen mit einer Flüssigkeit umfassen, wobei die Flüssigkeit thermisch an ein externes Wärmereservoir oder eine externe Wärmequelle oder eine externe Wärmesenke gekoppelt ist, und wobei mindestens ein Volumenänderungselement in wenigstens einem der Primärvolumina eine Änderung der Größe des Gasvolumens bewirkt, **dadurch gekennzeichnet, dass** sich der Anteil eines Wärmeübertragungselements, der sich im Flüssigkeitsvolumen befindet, periodisch ändert.

10. Verfahren aus Anspruch 9, **dadurch gekennzeichnet, dass** sich permanent eine Flüssigkeit im Flüssigkeitsvolumen befindet.

11. Verfahren aus Anspruch 9 oder 10, **dadurch gekennzeichnet, dass** das Volumenänderungselement durch die elektromagnetischen Komponenten periodisch bewegt oder verformt wird und/oder die Bewegung oder Verformung des Volumenänderungselements durch die elektromagnetischen Komponenten gesteuert oder geregelt wird.

12. Verfahren aus einem der Ansprüche 9 bis 11, **dadurch gekennzeichnet, dass** die Amplitude der Bewegung des Volumenänderungselements so gesteuert wird, dass die Geschwindigkeit des Volumenänderungselements beim Durchgang durch den Bewegungsmittelpunkt größer als die Geschwindigkeit einer harmonischen Schwingung gleicher Periodendauer ist.

13. Verfahren aus einem der Ansprüche 9 bis 12, **dadurch gekennzeichnet, dass** die Volumenänderungselemente in den Primärvolumina so bewegt werden, dass sich während einer Kompressionsphase ein Vielfaches des Arbeitsgases des ersten Primärvolumens im zweiten Primärvolumen befindet und während einer Expansionsphase sich ein Bruchteil des Arbeitsgases des ersten Primärvolumens im zweiten Primärvolumen befindet.

14. Verfahren aus einem der Ansprüche 9 bis 13, **dadurch gekennzeichnet, dass** die Volumenänderung des Gasvolumens durch Änderung des Anteils des Flüssigkeitsvolumens am Primärvolumen erfolgt.

**Claims**

1. Thermoelectric converter for converting quantities of heat into electric energy, or electric energy into quantities of heat, or quantities of heat of certain temperatures into quantities of heat of certain other temperatures, comprising at least two primary volumes connected to each other by at least one connecting element, the primary volumes each comprising one gas volume that is suited for receiving gas, and wherein at least one of the primary volumes or both comprise a liquid volume suited for receiving a liquid, wherein the liquid can be thermally coupled to an external heat reservoir or an external source of heat or an external heat sink, and wherein at least one volume-changing element is provided in at least one of the primary volumes for changing the size of the gas volume, **characterized in that** a heat transfer element is provided in at least one of the primary volumes, the proportion of the heat transfer element located in the liquid volume being variable.

2. Device of claim 1, **characterized in that** the heat transfer element comprises a surface area which is larger than the surface area of the surfaces defining the gas volume.

3. Device of claim 1 or 2, **characterized in that** the heat transfer element is either fixed to the surface of the volume-changing element facing the liquid volume, or is firmly provided at the surfaces defining the primary volume.

4. Device of one of claims 1 to 3, **characterized in that** the heat transfer element at least comprises:

   a plurality of separate plates consisting of a material that is a good heat conductor, such as metals;
   a plurality of separate rods, consisting of a material that is a good heat conductor, such as metals;
   a metallic foam permeable to liquids and gases;
   a plurality of grids connected to each other, consisting of a material that is a good heat conductor, such as metals;
   an arrangement of a material that is a good heat conductor with spaces whose dimensions into at least one direction are < 20 mm, preferably < 10 mm, preferably < 2 mm.

5. Device of one of claims 1 to 4, **characterized in that** electromagnetic components are provided which are suited for a movement of the volume-changing element.

6. Device of one of claims 1 to 5, **characterized in that** the volume-changing element is one of:

   a shifting piston,
   a rotary piston,
   a movable membrane,
   a movable regenerator,
   the liquid.

**7.** Device of one of claims 1 to 6, **characterized in that** at least at one volume-changing element or the surfaces defining the primary volume, a possibly movable absorber is provided which can convert electromagnetic radiation into heat and transmit it to the process gas.

**8.** Device of one of claims 1 to 7, **characterized in that** the device is one of:

> an alpha Stirling machine,
> a duplex-alpha Stirling machine,
> a multiple-acting alpha Stirling machine,
> a gamma or beta Stirling machine,
> a duplex-gamma or duplex-beta Stirling machine,
> a multiple-acting gamma or beta Stirling machine,
> a Vuilleumier cycle machine.

**9.** Method for converting quantities of heat into electric energy, or electric energy into quantities of heat, or quantities of heat of certain temperatures into quantities of heat of certain other temperatures, by means of a thermoelectric converter comprising at least two primary volumes connected to each other by at least one connecting element, each primary volume comprising a gas volume with a process gas, and wherein at least one of the primary volumes or both comprise a liquid volume with a liquid, the liquid being thermally coupled to an external heat reservoir or an external source of heat or an external heat sink, and wherein at least one volume-changing element causes a change of the size of the gas volume in at least one of the primary volumes, **characterized in that** the proportion of a heat transfer element located in the liquid volume changes periodically.

**10.** Method of claim 9, **characterized in that** liquid is permanently present in the liquid volume.

**11.** Method of claim 9 or 10, **characterized in that** the volume-changing element is periodically moved or deformed by the electromagnetic components, and/or the movement or deformation of the volume-changing element is controlled by the electromagnetic components by open-loop or closed-loop control.

**12.** Method of one of claims 9 to 11, **characterized in that** the amplitude of the movement of the volume-changing element is controlled such that the speed of the volume-changing element, when it passes the center of motion, is higher than the speed of a harmonic oscillation of the same period.

**13.** Method of one of claims 9 to 12, **characterized in that** the volume-changing elements are moved in the primary volumes such that during a compression phase, a multiple of the process gas of the first primary volume is located in the second primary volume, and during an expansion phase, a fraction of the process gas of the first primary volume is located in the second primary volume.

**14.** Method of one of claims 9 to 13, **characterized in that** the volume change of the gas volume is accomplished by changing the proportion of the liquid volume in the primary volume.

**Revendications**

**1.** Convertisseur thermoélectrique pour convertir des quantités de chaleur en énergie électrique, ou de l'énergie électrique en quantités de chaleur, ou des quantités de chaleur avec certaines températures en des quantités de chaleur avec certaines autres températures, le convertisseur comprenant au moins deux volumes primaires reliés mutuellement par au moins un élément de liaison, et comportant chacun un volume de gaz adapté à contenir un gaz, et au moins un des volumes primaires ou les deux comportant un volume de liquide adapté à contenir un liquide, le liquide pouvant être couplé thermiquement à un réservoir calorifique extérieur ou à une source de chaleur extérieure ou à un dissipateur thermique, et au moins un élément de modification de volume étant prévu dans au moins un des volumes primaires pour modifier la grandeur du volume de gaz,
**caractérisé**
**en ce qu'**un élément de transfert de chaleur est prévu dans au moins un des volumes primaires, la part de l'élément de transfert de chaleur, qui se trouve dans le volume de liquide, étant variable.

**2.** Dispositif selon la revendication 1, **caractérisé en ce que** l'élément de transfert de chaleur présente une superficie, qui est plus grande que la superficie des surfaces délimitant le volume de gaz.

**3.** Dispositif selon la revendication 1 ou la revendication 2, **caractérisé en ce que** l'élément de transfert de chaleur
soit est fixé à la surface dirigée vers le volume de liquide, de l'élément de modification de volume,
soit est prévu de manière fixe sur les surfaces délimitant le volume primaire.

**4.** Dispositif selon l'une des revendications 1 à 3, **caractérisé en ce que** l'élément de transfert de chaleur comprend au moins :

> un grand nombre de plaques séparées les unes des autres, réalisées en un matériau bon conducteur de la chaleur, comme par exemple des métaux ;
un grand nombre de barres séparées, réalisées en un matériau bon conducteur de la chaleur, comme par exemple des métaux ;
une mousse de métal perméable aux liquides et aux gaz ;
un grand nombre de treillis reliés mutuellement, réalisés en un matériau bon conducteur de la chaleur, comme par exemple des métaux ;
un agencement en un matériau bon conducteur de la chaleur avec des espaces intermédiaires, dont la dimension dans au moins une direction < 20 mm, de préférence < 10 mm, et en particulier < 2 mm.

5. Dispositif selon l'une des revendications 1 à 4, **caractérisé en ce que** sont prévus des composants électromagnétiques, qui sont adaptés à assurer un mouvement de l'élément de modification de volume.

6. Dispositif selon l'une des revendications 1 à 5, **caractérisé en ce que** l'élément de modification de volume est un élément sélectionné parmi :

   un piston coulissant en translation,
   un piston rotatif,
   une membrane mobile,
   un régénérateur mobile,
   le liquide.

7. Dispositif selon l'une des revendications 1 à 6, **caractérisé en ce que** sur au moins un élément de modification de volume ou sur les surfaces délimitant le volume primaire, il est prévu un absorbeur éventuellement mobile, qui peut convertir du rayonnement électromagnétique en chaleur et la transmettre au gaz de travail.

8. Dispositif selon l'une des revendications 1 à 7, **caractérisé en ce que** le dispositif est élément sélectionné parmi :

   une machine ou un moteur Stirling alpha,
   une machine ou un moteur Stirling alpha duplex,
   une machine ou un moteur Stirling alpha à effets multiples,
   une machine ou un moteur Stirling beta ou gamma,
   une machine ou un moteur Stirling beta duplex ou gamma duplex,
   une machine ou un moteur Stirling beta ou gamma à effets multiples,
   une machine ou moteur de Vuilleumier.

9. Procédé pour convertir des quantités de chaleur en énergie électrique, ou de l'énergie électrique en quantités de chaleur, ou des quantités de chaleur avec certaines températures en des quantités de chaleur avec certaines autres températures, à l'aide d'un convertisseur thermoélectrique, qui comprend au moins deux volumes primaires reliés mutuellement par au moins un élément de liaison et comportant chacun un volume de gaz avec un gaz de travail, et au moins un des volumes primaires ou les deux comportant un volume de liquide avec un liquide, le liquide pouvant être couplé thermiquement à un réservoir calorifique extérieur ou à une source de chaleur extérieure ou à un dissipateur thermique, et au moins un élément de modification de volume produisant dans au moins un des volumes primaires, une modification de la grandeur du volume de gaz, **caractérisé en ce que** la part d'un élément de transfert de chaleur, qui se trouve dans le volume de liquide, varie périodiquement.

10. Procédé selon la revendication 9, **caractérisé en ce qu'**un liquide se trouve en permanence dans le volume de liquide.

11. Procédé selon la revendication 9 ou la revendication 10, **caractérisé en ce que** l'élément de modification de volume est déplacé ou déformé périodiquement par les composants électromagnétiques, et/ou le déplacement ou la déformation de l'élément de modification de volume est commandé ou régulé par les composants électromagnétiques.

12. Procédé selon l'une des revendications 9 à 11, **caractérisé en ce que** l'amplitude du mouvement de l'élément de modification de volume est commandée de manière à ce que la vitesse de l'élément de modification de volume lors du passage par le point médian de déplacement soit supérieure à la vitesse d'une oscillation harmonique de même durée de période.

13. Procédé selon l'une des revendications 9 à 12, **caractérisé en ce que** les éléments de modification de volume sont déplacés dans les volumes primaires de façon à ce que, pendant une phase de compression, un multiple de la quantité du gaz de travail du premier volume primaire se trouve dans le deuxième volume primaire, et que pendant une phase d'expansion, une fraction du gaz de travail du premier volume primaire se trouve dans le deuxième volume primaire.

14. Procédé selon l'une des revendications 9 à 13, **caractérisé en ce que** la variation de volume du volume de gaz s'effectue en faisant varier la part du volume de liquide dans le volume primaire.

FIG. 1

FIG. 2a

FIG. 2b

FIG. 2c

FIG. 2d

FIG. 3

EP 2 657 497 B1

FIG. 4

FIG. 5

FIG. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2258947 A1
- WO 2008146109 A